# EUROPÄISCHE PATENTANMELDUNG

(11) **EP 4 848 969 A1**
(43) Veröffentlichungstag der Anmeldung: **02.12.2026**
(21) Anmeldenummer: 26175272.9
(22) Anmeldetag: 29.04.2026
(51) Int. Cl.: H10W 40/25, D03D 1/00, H10W 40/70

(54) **WÄRMELEITELEMENT, VERFAHREN ZU DESSEN HERSTELLUNG UND VORRICHTUNG**

(30) Priorität: 27.05.2025 DE 102025120592
(71) Anmelder: AUMOVIO Germany GmbH, 60488 Frankfurt am Main (DE)
(72) Erfinder: Wolff, Matthias, 60488 Frankfurt am Main (DE)
(74) Vertreter: Aumovio Corporation

(57) **Zusammenfassung**

Die vorliegende Erfindung betrifft ein Wärmeleitelement 100 mit einem Grundkörper 102 mit einer ersten Flächenseite 104 und einer in einer Dicke 106 zur ersten Flächenseite 104 parallel angeordneten zweiten Flächenseite 108, einer zur Dicke 106 senkrechten Querrichtung 110 und einer zur Dicke 106 und zur Querrichtung 110 senkrechten Längsrichtung 112. Kohlefaser-Kettfäden 114 erstrecken sich entlang der Querrichtung 110, wobei die Kohlefaser-Kettfäden 114 entlang der Längsrichtung 112 angeordnet sind und dabei Hohlräume 116 entlang der Längsrichtung 112 umschließen. Dabei kontaktieren die Kohlefaser-Kettfäden 114 die erste Flächenseite 104 und die zweite Flächenseite 108 thermisch miteinander. Eine Elastomer-Füllung 118 füllt den Grundkörper 102 aus, ohne die Hohlräume 116 zu verschließen.

## Beschreibung

### Technisches Gebiet

Die vorliegende Erfindung betrifft die Kühlung elektronischer Komponenten. Insbesondere betrifft die vorliegende Erfindung ein Wärmeleitelement und ein Verfahren zu dessen Herstellung. Weiterhin betrifft die vorliegende Erfindung eine Vorrichtung, in welcher das Wärmeleitelement zum Einsatz kommt.

### Technischer Hintergrund und Aufgabe

Die Kühlung bzw. Entwärmung elektronischer Komponenten ist zunehmend mit erhöhten mechanischen Anforderungen konfrontiert. Durch die wachsende Fläche der Mikroprozessoren (besonders bei "lidless", also Bauformen ohne Deckel) und der gleichzeitig ansteigende Verlustleistung existiert kein TIM (thermal interface material), was den thermischen und mechanischen Anforderungen über die gesamte Lebensdauer gerecht wird. Insbesondere die mechanischen Anforderungen, um eine Verwölbung bei hohen Temperaturen über die Lebensdauer, können häufig nicht erreicht werden. Durch die hohen Verlustleistungen sind dünne Wärmeleitmaterialien mit guter Wärmeleitung erforderlich. Diese neigen aber durch die Verwölbung zum Abriss oder Auspressen der Kühl-Massen und somit zum Verlust der Thermischen Anbindung.

Es ist daher die Aufgabe der vorliegenden Erfindung, ein Wärmeleitelement mit hoher mechanischer Stabilität zur Verfügung zu stellen. Weiterhin ist es Aufgabe der Erfindung, ein Verfahren zu dessen Herstellung sowie eine Vorrichtung zur Kühlung elektronischer Komponenten bereitzustellen.

### Offenbarung der Erfindung

Die Aufgabe wird erfindungsgemäß durch die Merkmale der Hauptansprüche gelöst. Vorteilhafte Ausgestaltungen können den Unteransprüchen entnommen werden.

Gemäß eines Aspekts der Erfindung weist ein Wärmeleitelement einen Grundkörper mit einer ersten Flächenseite und einer in einer Dicke zur ersten Flächenseite parallel angeordneten zweiten Flächenseite, einer zur Dicke senkrechten Querrichtung und einer zur Dicke und zur Querrichtung senkrechten Längsrichtung auf. Der Grundkörper kann also beispielsweise quader- oder zylinderförmig oder als Dreieckstab (Stab mit dreieckigem Profil/Querschnitt) ausgebildet sein. Typischerweise ist die Dicke deutlich geringer als eine Ausdehnung des Grundkörpers in Quer- oder Längsrichtung.

Weiterhin weist das Wärmeleitelement Kohlefaser-Kettfäden auf. Jede der Kohlefaser-Kettfäden erstrecken sich entlang der Querrichtung. Die Kohlefaser-Kettfäden sind dabei entlang der Längsrichtung angeordnet und umschließen Hohlräume entlang der Längsrichtung. Außerdem koppeln die Kohlefaser-Kettfäden die erste Flächenseite und die zweite Flächenseite thermisch miteinander.

Ist der Grundkörper quaderförmig, erstrecken sich die einzelnen Kohlefaser-Kettfäden also von einer Längsseite zur anderen (entlang der Querrichtung). Mehrere Kohlefaser-Kettfäden sind in Längsrichtung hintereinander angeordnet, so dass sie ein Volumen, welches beispielsweise zylinderförmig sein kann, umschließen. Dazu weisen sie beispielsweise Windungen und/oder Knicke auf.

Weiterhin weist das Wärmeleitelement eine Elastomer-Füllung auf, welche den Grundkörper ausfüllt, ohne die Hohlräume zu verschließen. Auch ein Elastomer leitet Wärme, aber nicht so effizient wie Kohlefaser. Außerdem kann es mechanisch nicht zur Stabilität des Wärmeleitelements beitragen, wenn es gequetscht oder gestreckt wird. Im Wärmeleitelement erfüllt es den Zweck, die Kohlefaser-Kettfäden in Form zu halten und gleichzeitig einen Beitrag zum Wärmetransport zu leisten.

Die erste und zweite Flächenseite ist zur Wärmeaufnahme bzw. -abgabe vorgesehen. Wird beispielsweise die erste Flächenseite von einer elektronischen Komponente und die zweite Flächenseite von einem Kühlkörper kontaktiert, so kann Wärme von der elektronischen Komponenten effizient mittels der Kohlefaser-Kettfäden zum Kühlkörper transportiert werden. Die Hohlräume bieten Platz, damit sich das Wärmeleitelement unter mechanischem Stress (Druck etc. bei Verwölbung der elektronischen Komponente oder des Kühlkörpers) stauchen lässt. Damit kommt es nicht zum Abriss des Wärmeleitelements und die Lebensdauer der gesamten Baugruppe erhöht sich. Durch den Einbau von Ausgleichszonen (Hohlräume) kann das Wärmeleitmaterial sich verändernde Spaltabstände ausgleichen.

Bevorzugt sind die erste Flächenseite und die zweite Flächenseite des Grundkörpers rund, rechteckig oder oval ausgebildet. Dies ermöglicht einen vielseitigen Einsatz. Prinzipiell sind aber auch Freiform-Geometrien möglich.

Bevorzugt besteht die Elastomer-Füllung aus einem Silikon-Elastomer. Dies ist ein weitläufig verfügbares und günstiges Material.

Bevorzugt weisen die Hohlräume in Querrichtung einen runden, dreieckigen, ovalen, oder rechteckigen Querschnitt aufweist. Dies ermöglicht vielseitige Möglichkeiten zur Optimierung der Wärmeleitung und der Federwirkung in einer Richtung entlang der Dicke.

Bevorzugt sind Spitzen von in Querrichtung nebeneinander angeordneten Hohlräumen mit dreieckigem Querschnitt alternierend zur ersten Flächenseite und zur zweiten Flächenseite angeordnet. Diese Geometrie ermöglicht eine sehr dichte Packung der Hohlräume und eine hohe Federkraft in einer Richtung entlang der Dicke.

Gemäß eines weiteren Aspekts der Erfindung weist ein Verfahren zur Herstellung eines Wärmeleitelementes einen Schritt auf, in dem ein Gewebes aus PVA-Schussfäden und Kohlefaser-Kettfäden gewebt wird. PVA (Polyvinylalkohol) ist ein thermoplastischer Kunststoff. Die Hohlräume sind also zunächst gefüllt von den PVA-Schussfäden. Verfahren zum Weben mittels Schussfaden (hier aus PVA) und Kettfaden (hier aus Kohlefasern) sind im Stand der Technik hinlänglich bekannt. Häufig reicht ein einzelner Schussfaden aus, um das Gewebe herzustellen.

Weiterhin weist das Verfahren einen Schritt auf, in welchem das Gewebe in eine Elastomer-Füllung eingebettet wird. Dies kann beispielsweise durch Einlegen des Gewebes in eine Form und dann durch Befüllen der Form mit einem Elastomer geschehen. Alternativ kann das Elastomer auch von beiden Seiten auf das Geweben bestrichen, gespritzt oder ähnliches werden. Oder das Gewebe wird durch ein Gefäß, gefüllt mit Elastomer, gezogen und anschließen in Form gepresst, wobei überschüssiges Elastomer entfernt wird. Es ist wichtig, dass hierbei die Kohlefaser-Kettfäden an oder sehr nah an der Oberfläche (erste/zweite Flächenseite) angeordnet sind, damit vorteilhafte thermische Eigenschaften beobachtet werden können.

Weiterhin weist das Verfahren einen Schritt auf, in welchem die PVA-Schussfäden ausgewaschen werden. PVA ist unter bestimmten Bedingungen (Temperatur, pH-Wert des Wassers, PVA-Typ, Agitation oder Rühren während des Auswaschens) wasserlöslich. Sind die PVA-Schussfäden ausgewaschen, entstehen an ihrer Stelle die Hohlräume, welche Platz für Ausdehnung des Wärmeleitelementes unter mechanischer Belastung bieten. Das Verfahren eignet sich damit, ein wie zuvor beschriebenes Wärmeleitelement herzustellen.

Es ist auch möglich, die Materialien für Kett- und Schussfäden zu tauschen. Die Kohlefaser-Schussfäden würden sich um die auswaschbaren PVA-Kettfäden legen.

Bevorzugt werden daher anstelle der Kohlefaser-Kettfäden, PVA-Kettfäden genutzt und anstelle der PVA-Schussfäden, Kohlefaser-Schussfäden genutzt.

Bevorzugt wird nach dem Auswaschen das Wärmeleitelement in rechteckige, runde, ovale, dreieckige oder rautenförmige Form gestanzt oder geschnitten wird. So ist auf einfache Weise prinzipiell jede geometrische Ausbildung des Wärmeleitelements möglich.

Bevorzug sind die PVA-Schussfäden als Vollzylinder, Hohlzylinder, Dreieckstab oder hohlem Dreieckstab ausgebildet sind. Eine hohle Ausführung kann beispielsweise die Zeit zum Auswaschen reduzieren. Eine nicht-hohle Ausführung dagegen kann vorteilhaft sein, die Hohlräume gleichmäßiger zu gestalten.

Gemäß eines weiteren Aspekts der Erfindung weist eine Vorrichtung zur Kühlung einer elektronischen Komponente neben der elektronischen Komponente einen Kühlkörper ein wie zuvor beschriebenes Wärmeleitpad auf, welches zwischen der elektronischen Komponente und dem Kühlkörper angeordnet ist. Bei der elektronischen Komponente kann es sich um eine einzelne Komponente wie einen Prozessor, Speicher, Grafikprozessor, ECU (electronic control unit) oder ähnliches handeln; oder auch um eine diese Einzelkomponenten aufweisende Komponentenanordnung.

### Kurzfassung der Figuren

Die Erfindung wird nachfolgend anhand von Ausführungsbeispielen mit Hilfe von Figuren näher erläutert. Die Figuren zeigen:
- Figur 1:: Perspektivische Ansicht eines ersten Ausführungsbeispiels eines Wärmeleitelements;
- Figur 2:: Querschnitt eines zweiten Ausführungsbeispiels eines Wärmeleitelements;
- Figur 3:: Querschnitte verschiedener Ausführungsformen von Hohlräumen;
- Figur 4:: Flussdiagramm eines Ausführungsbeispiels eines Verfahrens zur Herstellung eines Wärmeleitelementes;
- Figur 5:: Querschnitte verschiedener Ausführungsformen von PVA-Schussfäden;
- Figur 6:: Querschnitt eines Gewebes; und
- Figur 7:: Querschnitt eines Ausführungsbeispiels einer Vorrichtung zur Kühlung einer elektronischen Komponente.

### Detaillierte Beschreibung der Figuren

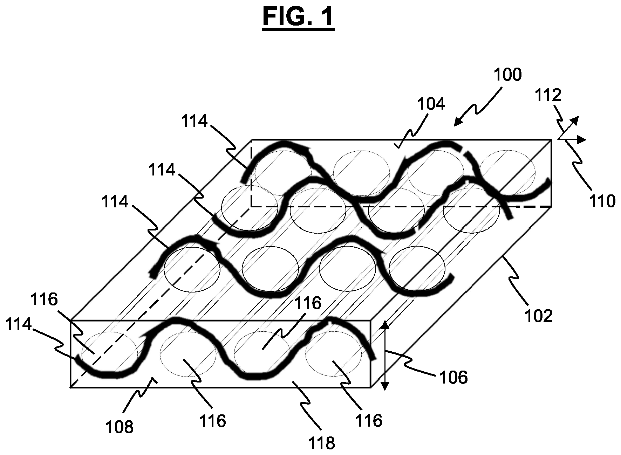

Figur 1 zeigt eine perspektivische Ansicht eines ersten Ausführungsbeispiels eines Wärmeleitelements 100.

Das Wärmeleitelement 100 weist einen Grundkörper 102 auf, welcher im Beispiel von Figur 1 als Quader ausgeführt ist. Der Grundkörper 102 weist daher eine erste Flächenseite 104 und eine zweite Flächenseite 108 auf. Diese sind parallel zueinander einer in einer Dicke 106 angeordnet. Die anderen Seiten des Grundkörpers 102 weisen eine deutlich kleinere Oberfläche auf als die Flächenseiten 104,108, somit ist der Grundkörper 102 flach ausgeführt. Dies erhöht den Wärmetransport zwischen den Flächenseiten 104,108, denn diese sind vorgesehen, Wärme von einer Wärmequelle zu einer Wärmesenke zu transportieren. Dazu kontaktieren die Flächenseiten 104,108 die Wärmequelle bzw. Wärmesenke.

Senkrecht zur Dicke 106 ist eine Querrichtung 110 definiert. Eine Längsrichtung 112 ist senkrecht sowohl zur Querrichtung 110 als auch zur Dicke 106 definiert. Für den beispielhaft in Figur 1 gezeigten quaderförmigen Grundkörper 102 fallen die Längsrichtung 112 und die Querrichtung 110 mit Ausdehnungsrichtungen des Grundkörpers 102 zusammen. Für andere geometrische Ausbildungen des Grundkörpers 102, beispielsweise ein Zylinder, ist dies nicht unbedingt der Fall.

Im Grundkörper 102 sind Hohlräume 116 angeordnet. Jeder Hohlraum 116 erstreckt sich entlang der Längsrichtung 112 durch den gesamten Grundkörper 102. Mehrere Hohlräume 116 sind parallel nebeneinander in Querrichtung 110 angeordnet. Durch Herstellungstoleranzen können die Hohlräume 116 auch nur im Wesentlichen parallel zueinander sein.

Weiterhin erstrecken sich Kohlefaser-Kettfäden 114 entlang der Querrichtung 110 innerhalb des Grundkörpers 102. Mehrere Kohlefaser-Kettfäden 114 sind hintereinander in entlang der Längsrichtung 112 angeordnet. Im Beispiels von Figur 1 folgen die Kohlefaser-Kettfäden 114 im Wesentlichen einer Sinus-förmigen Kontur. Bei benachbarten Kohlefaser-Kettfäden 114 sind Wellenberge um 90° phasenverschoben. Aus Gründen der Übersichtlichkeit wurde in Figur 1 außerdem der Abstand zwischen benachbarten Kohlefaser-Kettfäden 114 vergrößert dargestellt; diese sind eigentlich eng aneinander angeordnet oder kontaktieren sich sogar. Die Gesamtheit der Kohlefaser-Kettfäden 114 umschließen somit die Hohlräume 116.

Der Grundkörper 102 ist dort, wo weder Hohlräume 116 noch Kohlefaser-Kettfäden 114 angeordnet sind, mit eine Elastomer-Füllung 118, beispielsweise ein Silikon-Elastomer, befüllt. Diese hält die Kohlefaser-Kettfäden 114 in Form, damit diese die erste Flächenseite 104 und die zweite Flächenseite 108 kontaktieren und damit thermisch koppeln. Die Kohlefaser-Kettfäden 114 erfüllen damit eine doppelte Funktion: Sie leiten Wärme von der ersten Flächenseite 104 zur zweiten Flächenseite 108 und stellen eine mechanische Federwirkung in einer Richtung parallel zur Dicke 106 bereit. Die Federwirkung ergibt sich dabei aus den mechanischen Eigenschaften der Kohlefaser-Kettfäden 114, ihrer Anordnung, sowie den Hohlräumen 116.

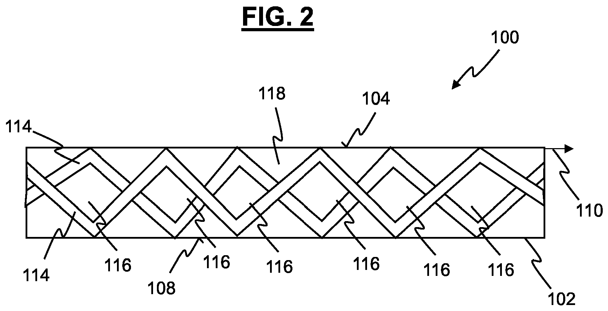

Figur 2 zeigt einen Querschnitt eines zweiten Ausführungsbeispiels eines Wärmeleitelements 100. Hier sind die Kohlefaser-Kettfäden 114 als Dreieckswellenmuster ausgebildet. Die so entstehenden Hohlräume 116 sind damit als Rauten ausgebildet.

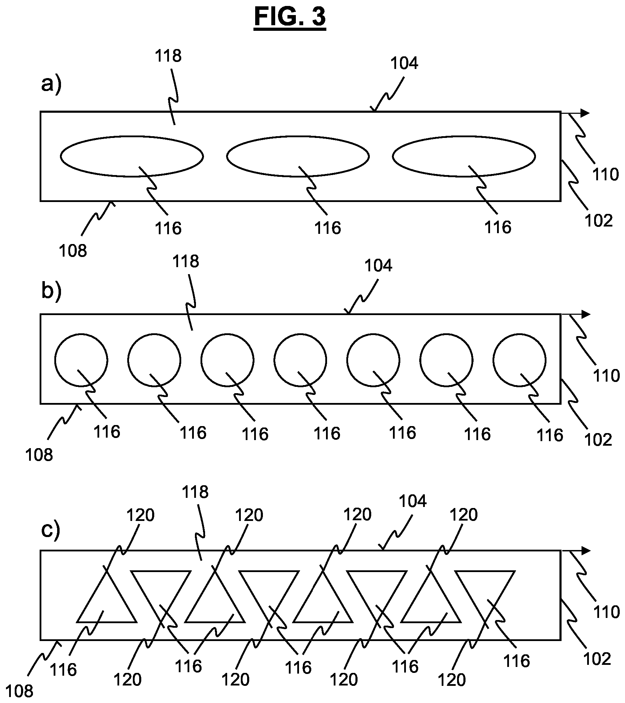

Figur 3 zeigt Querschnitte verschiedener Ausführungsformen von Hohlräumen 116. Dabei sind der Übersichtlichkeit halber die Kohlefaser-Kettfäden 114 nicht gezeigt.

Figur 3a) zeigt eine ovale, Figur 3b) eine runde und Figur 3c) eine dreieckige Ausführungsform der Hohlräume 116. Die Kohlefaser-Kettfäden 114 sind so anzuordnen, dass sie die Hohlräume 116 umschließen.

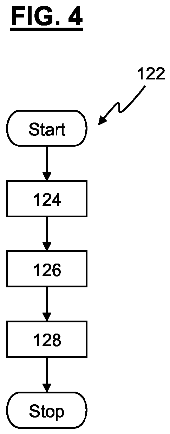

Figur 4 zeigt ein Flussdiagramm eines Ausführungsbeispiels eines Verfahrens 122 zur Herstellung eines Wärmeleitelementes 100.

Um ein Wärmeleitelement 100 wie aus Figur 1 herzustellen, weist das Verfahren 122 einen Webe-Schritt 124 auf, in welchem ein Gewebe 130 gewebt wird. Wie beim Weben üblich, wird hierzu ein Schussfaden und Kettfäden benötigt. Im Verfahren 100 werden dazu PVA-Schussfäden 132 und Kohlefaser-Kettfäden 114 genutzt. Es ist möglich, nur einen einzelnen PVA-Schussfaden 132 zu nutzen.

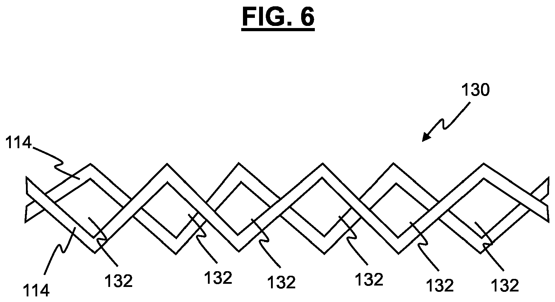

Das so entstehende Gewebe 130 ist in Figur 6 dargestellt. Hier sind die PVA-Schussfäden 132 rechteckig bzw. rautenförmig ausgeführt. Es ist möglich, diese auch rund oder mit einem anderen Querschnitt auszuführen.

Wieder Bezug nehmen auf Figur 4 wird, nachdem das Gewebe 130 gewebt wurde, dieses in einem Einbette-Schritt 126 in eine Elastomer-Füllung eingebettet. Das Gewebe 130 kann dazu beispielsweise in ein Bad mit einem Elastomer eingetaucht und in Form gebracht werden. Andere Methoden wie verkleben, besprühen, etc., sind möglich.

Anschließen werden in einem Auswasche-Schritt 128 die PVA-Schussfäden 132 ausgewaschen. PVA ist unter bestimmten Bedingungen (Wasser-)löslich. Nach dem Auswasche-Schritt 128 sind die PVA-Schussfäden 132 nicht mehr vorhanden und somit haben sich die weiter oben erwähnten Hohlräume 116 gebildet.

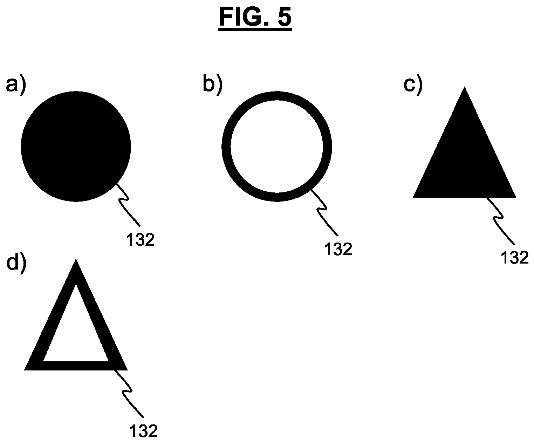

Figur 5 zeigt Querschnitte verschiedener Ausführungsformen von PVA-Schussfäden 132.

Figur 5a) zeigt PVA-Schussfäden 132 in Form eines Vollzylinders. Figur 5b) zeigt dagegen einen Querschnitt in Form eines Hohlzylinders. Figur 5c) zeigt PVA-Schussfäden 132 als Dreieckstab und Figur 5d) einen hohlem Dreieckstab. Die Form der PVA-Schussfäden 132 sowie gewählte Parameter im Webe-Schritt 124 (Kettfadenspannung, Schussdichte, Kettdichte, Bindung, Webbreite, Webgeschwindigkeit, Schussfadeneintrag, Fadenführung, etc.) habe Einfluss auf die geometrische Ausbildung der Hohlräume 116. Mit anderen Worten, mit Ihrer Hilfe kann die geometrische Ausbildung der Hohlräume 116 und der Kohlefaser-Kettfäden 114 gesteuert werden.

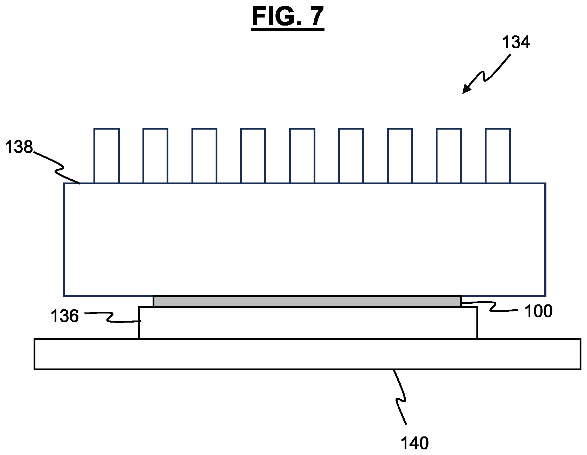

Figur 7 zeigt einen Querschnitt eines Ausführungsbeispiels einer Vorrichtung 134 zur Kühlung einer elektronischen Komponente 136.

Im Beispiel von Figur 7 ist die elektronische Komponente 136, beispielsweise ein Prozessor, eine Graphikkarte, ein Leistungstransistor, ein Spannungsregler oder ähnliches, auf einer Leiterplatte 140 befestigt. Im Übrigen kann es sich bei der elektronische Komponente 136 auch um eine Anordnung mehrere Komponenten handeln.

Die elektrische Komponente 136 erzeugt Wärme, welche zu einem Kühlkörper 138 abgeleitet werden soll. Um den Wärmeübergang zu verbessern und die Temperatur von der elektronischen Komponente 136 zu regulieren, indem Lücken zwischen unebenen Oberflächen gefüllt und so die Wärmeleitung optimiert wird, ist ein wie zuvor beschriebenes Wärmeleitelement 100 zwischen elektronischer Komponente 136 und Kühlkörper 138 angeordnet. Das Wärmeleitelement 100 kontaktiert sowohl die elektronische Komponente 136 als auch den Kühlkörper 138 und ermöglicht so die Wärmeübertragung.

### Bezugszeichenliste

- 100: Wärmeleitelement
- 102: Grundkörper
- 104: Flächenseite
- 106: Dicke
- 108: Flächenseite
- 110: Querrichtung
- 112: Längsrichtung
- 114: Kohlefaser-Kettfäden
- 116: Hohlräume
- 118: Elastomer-Füllung
- 120: Spitzen
- 122: Verfahren
- 124: Webe-Schritt
- 126: Einbette-Schritt
- 128: Auswasche-Schritt
- 130: Gewebe
- 132: PVA-Schussfäden
- 134: Vorrichtung
- 136: Elektronische Komponente
- 138: Kühlkörper
- 140: Leiterplatte

## Patentansprüche

1. Wärmeleitelement (100), aufweisend
a) einen Grundkörper (102) mit einer ersten Flächenseite (104) und einer in einer Dicke (106) zur ersten Flächenseite (104) parallel angeordneten zweiten Flächenseite (108), einer zur Dicke (106) senkrechten Querrichtung (110) und einer zur Dicke (106) und zur Querrichtung (110) senkrechten Längsrichtung (112),
b) Kohlefaser-Kettfäden (114), wobei jede der Kohlefaser-Kettfäden (114) sich entlang der Querrichtung (110) erstrecken, wobei die Kohlefaser-Kettfäden (114) entlang der Längsrichtung (112) angeordnet sind und dabei Hohlräume (116) entlang der Längsrichtung (112) umschließen, wobei die Kohlefaser-Kettfäden (114) die erste Flächenseite (104) und die zweite Flächenseite (108) thermisch koppeln, und
c) eine Elastomer-Füllung (118), welche den Grundkörper (102) ausfüllt, ohne die Hohlräume (116) zu verschließen.

2. Wärmeleitelement (100) nach Anspruch 1, **gekennzeichnet dadurch, dass** die erste Flächenseite (104) und die zweite Flächenseite (108) des Grundkörpers (102) rund, rechteckig oder oval ausgebildet ist.

3. Wärmeleitelement (100) nach Anspruch 1 oder 2, **gekennzeichnet dadurch, dass** die Elastomer-Füllung (108) aus einem Silikon-Elastomer besteht.

4. Wärmeleitelement (100) nach einem der vorhergehenden Ansprüche, **gekennzeichnet dadurch, dass** die Hohlräume (116) in Querrichtung (110) einen runden, dreieckigen, ovalen, oder rechteckigen Querschnitt aufweisen.

5. Wärmeleitelement (100) nach Anspruch 4, **gekennzeichnet dadurch, dass** Spitzen (120) von in Querrichtung (110) nebeneinander angeordneten Hohlräumen (116) mit dreieckigem Querschnitt alternierend zur ersten Flächenseite (104) und zur zweiten Flächenseite (108) angeordnet sind.

6. Verfahren (122) zur Herstellung eines Wärmeleitelementes (100), aufweisend die Schritte:
a) Weben (124) eines Gewebes (130) aus PVA-Schussfäden (132) und Kohlefaser-Kettfäden (114),
b) Einbetten (126) des Gewebes (130) in eine Elastomer-Füllung,
c) Auswaschen (128) der PVA-Schussfäden (132).

7. Verfahren (122) nach Anspruch 6, **gekennzeichnet dadurch, dass** nach dem Auswaschen (128) das Wärmeleitelement (100) in rechteckige, runde, ovale, dreieckige oder rautenförmige Form gestanzt oder geschnitten wird.

8. Verfahren (122) nach Anspruch 6 oder 7, **gekennzeichnet dadurch, dass** die PVA-Schussfäden (132) als Vollzylinder, Hohlzylinder, Dreieckstab oder hohlem Dreieckstab ausgebildet sind.

9. Verfahren (122) nach einem der Ansprüche 6 bis 8, **gekennzeichnet dadurch, dass** anstelle der Kohlefaser-Kettfäden (114), PVA-Kettfäden genutzt werden und dass anstelle der PVA-Schussfäden (132), Kohlefaser-Schussfäden genutzt werden.

10. Vorrichtung (134) zur Kühlung einer elektronischen Komponente (136), aufweisen:
a) die elektronische Komponente (136),
b) einen Kühlkörper (138), und
c) ein Wärmeleitpad (100) nach einem der Ansprüche 1 bis 5, welches zwischen der elektronischen Komponente (136) und dem Kühlkörper (138) angeordnet ist.
